# EUROPEAN PATENT APPLICATION

(11) **EP 0 993 109 A1**
(43) Date of publication of application: **12.04.2000**
(21) Application number: 99307505.0
(22) Date of filing: 22.09.1999
(51) Int. Cl.: H03B 9/14

(54) **Oscillators and a method of assembling oscillators**

(30) Priority: 08.10.1998 GB 9821832
(71) Applicant: Mitel Semiconductor Limited, Swindon, Wiltshire SN2 2QW (GB)
(72) Inventor: Bird, John, Burton Village, Lincoln (GB); Flatters, Gary Stephen, Swanpool, Lincoln (GB); Whitworth, Bernard, Thorney, Notts (GB)
(74) Representative: Pratt, David Martin

(57) **Abstract**

An oscillator body 10 defines a waveguide 11 in which is supported a Gunn diode 15. The Gunn diode 15 is thermally and electrically connected to a surface of a heat sink having a cylindrical main body 40 which is supported in the body 10 by an interference or tight sliding fit. A screw cap 46 may be used to retain the heat sink in the body 10. Use of an interference or tight sliding fit to support the heat sink in the body 10 eliminates concentricity variation problems encountered in the prior art and increases susceptibility to automated mass production.

## Description

The present invention relates to oscillators and in particular, although not exclusively, to Gunn diode oscillators susceptible to automated mass production. The present invention relates also to a method of assembling oscillators.

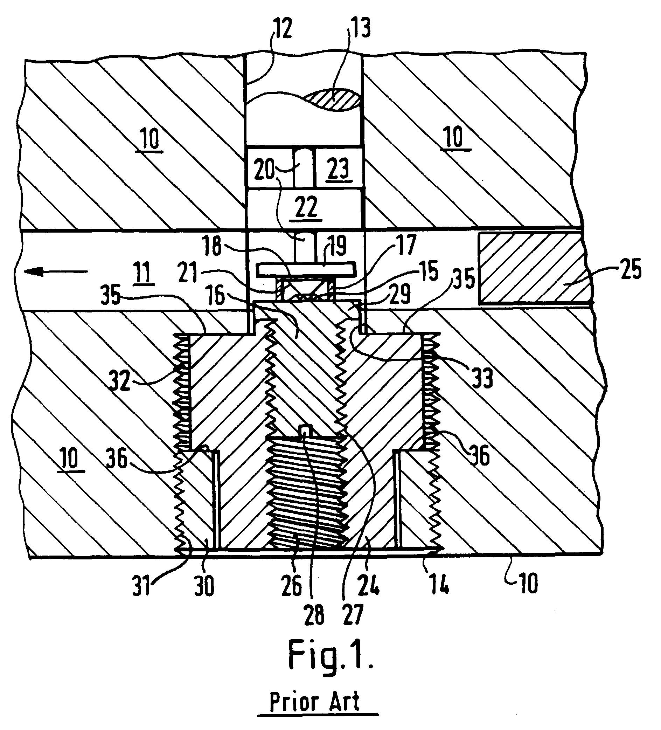

Gunn diode oscillators are important components of radar systems. They generate microwave frequency electromagnetic radiation from Gallium Arsenide substrates which are processed in a particular manner to form devices known as Gunn diodes. Application of a dc voltage across the Gunn diode causes high frequency electron pulses across junctions within it, which pulses cause an oscillating electric field to be set up in the vicinity of the Gunn diode. The Gunn diode is located in and supported by a metallic oscillator body, defining a waveguide and supporting other components of the oscillator, which uses the electric field to generate microwave frequency electromagnetic radiation. A prior art bias tuned second harmonic radial mode oscillator is shown in cross section in Figure 1.

In Figure 1, the Gunn diode oscillator comprises generally a body 10 in which is defined an elongate waveguide 11 of rectangular cross section, a bore 12 containing an RF choke 13, and a composite bore 14 on the opposite side of the waveguide 11 to the bore 12. A Gunn diode 15 is ultrasonically scrubbed onto the top surface of a gold plated first heat sink 16. The Gunn diode 15 is enclosed by an annular electrically insulating tube 17, which is made from alumina, and an electrically conductive lid 18. A gold plated radial disk 19 is held in contact with the lid 18 by application of a constant spring force on an electrically conducting connector 20, which passes along the central axis of the RF choke 13. The surface of the Gunn diode 15 closest to the RF choke 13 is electrically connected to the connector 20 by way of a wire bond or Maltese cross connection 21 made to the junction of the alumina tube 17 and the lid 18.

The RF choke 13 comprises alternate high impedance and low impedance sections. In this example, the low impedance section is a brass disk 22 and the high impedance section is of air 23. The thickness of each of the sections 22 and 23 is equal to one quarter of the wavelength of the electromagnetic radiation to be generated. Further low and high impedance sections 22 and 23 may be incorporated in the choke 13. The connector 20 and thus the radial disk 19 are electrically insulated from the oscillator body 10 by a layer of plastic material (not shown) which is wrapped around the substantially cylindrical form of the choke 13. The surface of the Gunn diode 15 furthest from the RF choke 13 is electrically and thermally connected to the oscillator body 10 by the first heat sink 16 and the second heat sink 24. The Gunn diode oscillator can be activated to generate microwave frequency electromagnetic radiation by application of a dc voltage across the oscillator body 10 and the electrical connector 20.

A short circuit 25, in the form of an elongate rectangular cross section metallic element, is movable axially the waveguide 11. Movement of the short circuit 25 relative to the position of the radial disk 19 and Gunn diode 15 causes variation of the output power of the oscillator, as will be appreciated by those skilled in the art. Microwave frequency electromagnetic energy is radiated in the direction of the arrow. The first heat sink 16 is connected to the second heat sink 24 by the mating of a threaded axial bore 26 of the second heat sink 24 and a screw thread 27 formed on the primary surface of the first heat sink 16. This connection is made by rotation of the first heat sink 16 relative to the second heat sink 24, achieved by rotation of a screwdriver or the like having a blade inserted in a groove 28 formed in the end of the heat sink 16 furthest from the RF choke 13, to screw the heat sinks 16 and 24 together. Rotation of these components is made until the surface of a flange 29 of the first heat sink 16 which is furthest from the RF choke 13 is in firm contact with a surface of the second heat sink 24 which is closest to the choke 13. A reasonable degree of thermal and electrical contact is thus made between the first and second heat sinks 16 and 24.

The second heat sink 24, and thus the first heat sink 16, is supported in the oscillator body 10 by the clamping action of an annular screw 30. The screw 30 has a thread 31 on its outer surface which mates with a threaded bore 32 of the composite bore 14. The second heat sink 24 is fixed relative to the body 10 by virtue of frictional forces at the washer shaped contact areas 35 and 36. A flange 29 of the first heat sink 16 and a part of the second heat sink 24 which is adjacent the flange 29 extend through a bore 33 linking the bore 32 with the waveguide 11 so that the Gunn diode 15 is supported in and located in the waveguide 11.

Because it is difficult to predict what effect the mating of the threads 26 and 27 will have on the concentricity of the outer cylindrical surface of the second heat sink 24 and the central axis of the first heat sink 16, it is usual to provide the bore 33 with a diameter 3 or 4% larger than the outer diameter of the flange 29. It has been found that the unscrewing of the annular screw 30 and subsequent re-screwing can cause the operating characteristics of the Gunn diode oscillator to change. In addition to a significant change in the level of the output power, a frequency change of up to 2% can occur as a result of such a re-assembly. This obviously introduces some undesirable variables into the characteristics that can be expected on oscillator assembly, even when tight component tolerances can be achieved. This frequency pulling and the changing of the output power has been thought to be caused by different alignment of the bond wires or Maltese cross connections 21 with respect to the axis of the waveguide 11. However, the inventor has found that the frequency pulling and output power change caused by the re-assembly is the result largely of the outer surface of the flange 29, and thus the outer surface of the part of the second heat sink 24 which is closest to the choke 13, being either more or less concentric with the bore 33 than previously. The concentricity has a bearing on the shape of the air gap between the outer surface of the heat sink 24 and the bore 33 and particularly on the minimum distance between the bore 33 and the outer surface of the heat sink 24. The inventor has performed experiments which show that the amount of frequency pulling is dependent on the amount of offset from concentric of the bore 33 and the outer surface of the flange 29 of the heat sink 16.

In accordance with a first aspect of the present invention, there is provided an oscillator for generating microwave frequency radiation comprising:
an oscillator body having formed therein a waveguide and a substantially cylindrical bore intersecting the waveguide; and
a package comprising a heat sink having a substantially cylindrical portion and an oscillatory semiconductor device supported at one end of the heat sink;
in which the diameter of the cylindrical portion of the heat sink in relation to the diameter of the bore is such that the heat sink is supported in the bore by an interference or tight sliding fit with the semiconductor device being located in the waveguide.

This oscillator is not susceptible to variations in frequency and output power which can occur due to variations in concentricity of the heat sink with the bore in which it is supported. This oscillator is also likely to be cheaper to produce than the prior art oscillators because it is not necessary to form the heat sink package with a threaded outer surface, or to form a second heat sink with a threaded bore. This oscillator is also likely to have greater surface area contact, because of the lack of threaded connections and because contact between the heat sink and the body can be made for all or much of the cylindrical outer surface of the heat sink, than the prior art oscillators. This increased contact will improve the thermal and electrical conductivity properties and is likely to improve the operating characteristics of the oscillator. This oscillator is more readily susceptible to automated mass production than the prior art oscillators because the controlled insertion of the package into the bore in the body is easily achievable by a robotic tool. Also, because the possibility that the package will move relative to the body may be substantially reduced, the possibility that the characteristics of the oscillator will change as a result of a mechanical knock or thermal cycling may also be reduced.

The interference or tight sliding fit preferably includes a layer of soft deformable material. The soft deformable material layer provides the advantage of lubricating the interference fitting of the package and the bore. The package may be barrel plated with soft gold to provide the layer. The plating may for example be 15µm thick.

A surface of the heat sink adjacent the diode is preferably substantially flush with or slightly proud of a surface of the waveguide. This feature may ease mass production of the oscillator in that protrusion of the heat sink into the waveguide can be detected optically or mechanically, the detection being used to control the insertion of the package into the body.

The bore may be formed by the reaming of a rough bore formed in the body. This allows the diameter of the bore to be very accurately determined, thus assisting the interference fit. The rough bore may be formed by die casting the body. Cost savings can be achieved by allowing the body to be die cast in this way, prior art second harmonic oscillator bodies not being thought to be susceptible to die casting.

The body may comprise a second bore on the opposite side of the first bore to the waveguide, the second bore being threaded to allow a screw cap to retain the package within the oscillator body. This feature eliminates any possibility that the Gunn diode package will be dislodged by the spring force of the RF choke.

In accordance with a second aspect of the present invention, there is provided a method of assembling an oscillator for generating microwave frequency radiation, the oscillator comprising: an oscillator body having formed therein a waveguide and a substantially cylindrical bore intersecting the waveguide; and a package comprising a heat sink having a substantially cylindrical portion and an oscillatory semiconductor device supported at one end of the heat sink; in which the diameter of the cylindrical portion of the heat sink is larger than the diameter of the bore, the method comprising inserting the package into the bore such that the package is retained by an interference or tight sliding fit with the semiconductor device being located in the waveguide.

An embodiment of the present invention will now be described, by way of example only, with reference to the accompanying drawings, of which:
Figure 1 shows a prior art Gunn diode oscillator; and
Figure 2 shows an oscillator in accordance with the present invention in the form of a Gunn diode oscillator.

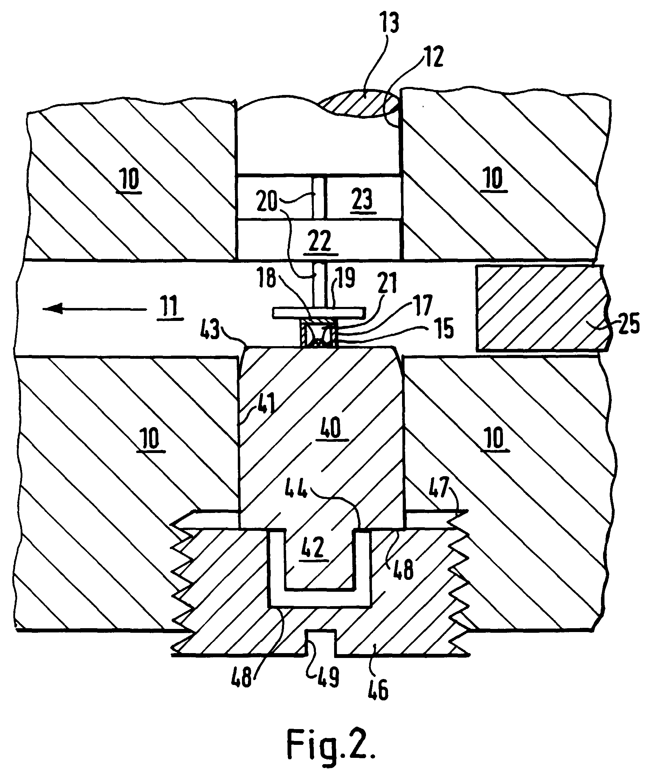

Referring to Figure 2, in which reference numerals have been retained for like elements, the Gunn diode oscillator comprises a heat sink 40 having a substantially cylindrical main body 40 and tail piece 42, the main body 40 of which is interference fitted in a bore 41 of the oscillator body 10. The heat sink 40, 42 with the Gunn diode 15, the alumina tube 17 and the lid 18 together form a Gunn diode package. The tail piece 42 is cylindrical and has a diameter equal to half of the diameter of the main body 40. The tail piece 42 is axial with the main body 40. The edge 43 of the main body 40 closest to the RF choke 13 is rounded or chamfered so as to ease entry of the heat sink 40, 42 into the bore 41 and to prevent swarf being pushed into the waveguide 11 during assembly. Insertion of the heat sink 40, 42 into the bore 41 is made by a robotic tool which grasps the tail piece 42 and forces it towards the RF choke 13. The robotic tool is controlled to discontinue application of this force when it is detected that the chamfered edge 43 of the main body 40 has extended into the waveguide 11. This can be achieved using conventional optical or mechanical techniques.

In producing the Gunn diode oscillator, the oscillator body 10 is die cast in an alloy of aluminium and zinc. The die cast oscillator body includes a cylindrical bore having a diameter which is less than the diameter of the bore 41. This rough bore is then reamed using a reamer to produce the bore 41. In this way, the bore 41 can be provided with dimensions which are very accurately predictable and controllable. The heat sink 40, 42 can then be inserted into the oscillator body 10 without further processing of the bore 41.

The heat sink 40, 42 is machined from a single piece of copper, and gold plated to a depth of 15µm using a barrel plating process. Barrel plating is preferred because it tends to deposit an even thickness of soft gold on the surfaces of the main body 40 which are of particular importance, i.e. the cylindrical outside surface which contacts the bore 41 when installed in the oscillator body 10. The barrel plating process also tends to deposit a layer of soft gold on the surfaces of the alumina tube 17 which are closest to the RF choke 13 in the drawing. This is advantageous in that it provides a good surface on which to attach the bond wires or Maltese cross connection 21.

The oscillator further comprises a screw cap 46 which mates with a threaded second bore 47 of the oscillator body 10. A surface 48 of the screw cap 46 connects with a surface 44 of the main body 40 which is closest to the tail piece 42 with a force which is determined by the final torque applied to a tool, and thus to a groove 49 of the screw cap 46, which is used to screw the screw cap 46 into the oscillator body 10. Although the screw cap 46 is not essential, its presence may be desired where the connector 20 of the RF choke 13 is spring loaded to apply a reasonably high force onto the package, or where there is a possibility that the heat sink 40, 42 will move relative to the oscillator body 10 for other reasons. The screw cap 46 need not be provided if the outer diameter of the main body 40 is sufficiently larger than the diameter of the bore 41 that the force required to dislodge the main body 40 in the oscillator body 10 will not be experienced under normal circumstances.

Where the oscillator is to operate in the frequency band of 76.1 to 76.9 GHz, the waveguide 11 will typically have a cross section of 3.10mm by 1.55mm. With this frequency band, the oscillator body is formed with a rough bore which has a diameter of 2.85mm and which intersects the waveguide 11 on its largest side and which is perpendicular to the axis of the waveguide 11. This bore is then reamed with a reamer to form the bore 41 with a diameter of no less than 2.900mm and no greater than 2.905mm. In this way, a heat sink having a cylindrical main body 40 with a diameter anywhere in the region of 2.91mm to 2.93mm, including the gold plating, will form a good interference or tight sliding fit when inserted into the bore 41 of the oscillator body 10. The primary requirement of this interference or tight sliding fit is that the air gap between the heat sink 40, 42 and the oscillator body 10 which is present in the prior art devices is avoided. Although it is not essential, it is preferred that the tight sliding or interference fit prevents the heat sink 40, 42 from moving relative to the oscillator body 10, except with the application of a large force onto the heat sink 40, 42.

Although the embodiment has described a Gunn diode oscillator, it will be appreciated that the present invention is also applicable to Impatt diode oscillators and the like where an oscillatory semiconductor device needs to be supported in a waveguide.

## Claims

1. An oscillator for generating microwave frequency radiation comprising:
an oscillator body (10) having formed therein a waveguide (11) and a substantially cylindrical bore (41) intersecting the waveguide; and
a package (40, 42) comprising a heat sink having a substantially cylindrical portion (40) and an oscillatory semiconductor device (15) supported at one end of the heat sink;
in which the diameter of the cylindrical portion (40) of the heat sink in relation to the diameter of the bore (41) is such that the heat sink is supported in the bore by an interference or tight sliding fit with the semiconductor device (15) being located in the waveguide (11).

2. An oscillator in accordance with Claim 1 in which the interference or tight sliding fit includes a layer of soft deformable material.

3. An oscillator in accordance with Claim 2 in which the package (40, 42) is barrel plated with soft gold to provide the layer.

4. An oscillator in accordance with any preceding claim in which a surface (43) of the heat sink adjacent the semiconductor device is substantially flush with or slightly proud of a surface of the waveguide (11).

5. An oscillator in accordance with any preceding claim in which the bore (41) is formed by the reaming of a rough bore formed in the body (10).

6. An oscillator in accordance with Claim 5 in which the rough bore is formed by die-casting the body (10).

7. An oscillator in accordance with any preceding claim in which the body (10) further comprises a second bore (12) on the opposite side of the first bore, to the waveguide, the second bore (47) being threaded to allow a screw cap (46) to retain the package (40, 42) within the body (10).

8. A method of assembling an oscillator for generating microwave frequency radiation, the oscillator comprising: an oscillator body (10) having formed therein a waveguide (11) and a substantially cylindrical bore (41) intersecting the waveguide (11); and a package (40, 42) comprising a heat sink having a substantially cylindrical portion (40) and an oscillatory semiconductor device (15) supported at one end of the heat sink (40, 42); in which the diameter of the cylindrical portion (40) of the heat sink is larger than the diameter of the bore (41), the method comprising inserting the package (40, 42) into the bore (47) such that the package is retained by an interference or tight sliding fit with the semiconductor device (15) being located in the waveguide (11).

9. A method in accordance with Claim 8 in which the interference or tight sliding fit includes a layer of soft deformable material.

10. A method in accordance with Claim 9 in which the package (40, 42) is barrel plated with soft gold to provide the layer.

11. A method in accordance with any of Claims 8 to 10 in which a surface (43) of the heat sink adjacent the semiconductor device is substantially flush with or slightly proud of a surface of the waveguide (11).

12. A method in accordance with any of Claims 8 to 11 in which the bore (41) is formed by the reaming of a rough bore formed in the body (10).

13. A method in accordance with Claim 12 in which the rough bore is formed by die- casting the body (10).

14. A method in accordance with any of Claims 8 to 13 in which the body (10) further comprises a second bore on the opposite side of the first bore to the waveguide, the second bore being threaded (47) to allow a screw cap (46) to retain the package within the body (10).
